Europäisches Patentamt

(19) European Patent Office

Office européen des brevets

(11) Publication number: **0 098 941**
**B1**

(12) **EUROPEAN PATENT SPECIFICATION**

(45) Date of publication of patent specification: **14.10.87**

(21) Application number: **83105022.4**

(22) Date of filing: **20.05.83**

(51) Int. Cl.⁴: **H 01 L 21/28, H 01 L 21/223**

(54) Method of making ohmic contacts regions and device manufactured by the method.

(30) Priority: **21.05.82 JP 85937/82**

(43) Date of publication of application:
**25.01.84 Bulletin 84/04**

(45) Publication of the grant of the patent:
**14.10.87 Bulletin 87/42**

(84) Designated Contracting States:
**DE FR GB**

(56) References cited:
**US-A-4 319 395**

**JOURNAL OF THE ELECTROCHEMICAL
SOCIETY, vol. 128, no. 11, November 1981,
Princeton, USA S. INOUE et al. "Phosphorus-
doped molybdenum silicide films for LSI
applications", pages 2402-2410**

**IBM TECHNICAL DISCLOSURE BULLETIN, vol.
24, no. 4, September 1981, New York C.M.
OSBURN et al. "Self-aligned silicide conduct
ors in FET integrated circuits", pages 1970-1973**

The file contains technical information
submitted after the application was filed and
not included in this specification

(73) Proprietor: **Kabushiki Kaisha Toshiba
72, Horikawa-cho Saiwai-ku
Kawasaki-shi Kanagawa-ken 210 (JP)**

(72) Inventor: **Kakumu, Masakazu
Toshiba Hiyoshi Ryo 171, 1020 Hiyoshi-Honcho
Kohoku-ku Yokohama-shi Kanagawa-ken (JP)**

(74) Representative: **Lehn, Werner, Dipl.-Ing. et al
Hoffmann, Eitle & Partner Patentanwälte
Arabellastrasse 4
D-8000 München 81 (DE)**

(56) References cited:
**IEEE TRANSACTIONS ON ELECTRON
DEVICES, vol. ED-2, no. 5, May 1976, New York
J. MIDDLEHOEK et al. "A polysilicon source and
drain MOS transistor (PSD MOST)", pages
523-525**

## Description

This invention relates to a method of manufacturing a field effect transistor (FET) in which the ohmic contacts of wiring portions and electrode portions thereof are improved.

Polycrystal silicon has been extensively employed for forming the electrodes and lead wires of a semiconductor device, because it is excellent in acid resisting characteristic and in heat resisting characteristic and it can be employed in a self-alignment method. However, it has been found that polycrystal silicon is high in specific resistance and not suitable for high speed operation of the element.

On the other hand, special attention has been paid to a method of using metal silicide; however, with metal silicide it is difficult to provide satisfactory ohmic contacts necessary for wiring. Therefore, a method in which a phosphorus-doped $MoSi_2$ film is used, or a method in which ions are implanted into the interface of an $MoSi_2$ film and an Si substrate, is employed. However, these methods suffer from drawbacks that they cannot use the existing facilities because they are not similar to the method in which polycrystal silicon is used, and that they are high in dangerousness and low in ohmic characteristic.

The Journal of the Electrochemical Society, Vol. 128, No. 11, Nov. 1981, pages 2402—2410, discloses a method of doping molybdenum silicide films with phosphorus to improve ohmic contacts. In detail, it discloses a method of manufacturing an FET, comprising forming a first insulating film on the surface of a semiconductor substrate, forming a metal silicide film on said insulating film and diffusing phosphorus into the surface of said substrate so as to form in the substrate an ohmic contact region. In this known method, the metal silicide film is formed by simultaneously evaporating molybdenum and silicon in a $PH_3$ atmosphere onto a substrate, and the phosphorus diffuses out from this doped $MoSi_2$-film into the substrate.

However, this method is unsatisfactory in so far as the diffusion depth of the phosphorus increases with each subsequent thermal process step, making the depth difficult to control and leading to increased contact resistance.

In view of the foregoing, an object of this invention is to provide a method of manufacturing a field effect transistor which has electrodes or lead wires of metal and metal silicide, which is excellent in the ohmic characteristic of the electrodes or lead wires with respect to the substrate, and which operates at high speed with high reliability.

According to the invention, there is provided a method of manufacturing an FET comprising:

forming a first insulating film on the surface of a semiconductor substrate;

removing a portion of said first insulating film from said substrate surface to form an exposed portion of said substrate;

forming a metal silicide film on said first insulating film and on said exposed portion of the substrate, by simultaneously evaporating metal and silicon onto said exposed portion and insulating film; thereafter

introducing impurities into the surface of said substrate from outside the metal silicide covered substrate through said metal silicide film so as to decrease the specific resistance of the metal silicide film and to form in said exposed portion of the substrate an ohmic contact region for the source and/or drain region of said FET; and

forming said source region and said drain region of said FET in said substrate.

Thus the step of forming an insulating film on the surface of a semiconductor substrate, the step of simultaneously evaporating metal and silicon on the insulating film and on a portion of the substrate surface from which the insulating film is removed, to form films for wiring and electrodes, and the step of introducing a large quantity of impurities into the surface of the semiconductor substrate are carried out before the step of forming the active semiconductor regions.

The nature, principle and utility of an embodiment of the invention will become more apparent from the following detailed description when read in conjunction with the accompanying drawings.

In the accompanying drawings:

FIGS. 1A through 1D are explanatory diagrams showing manufacturing steps in a first embodiment of this invention;

FIGS. 2A through 2D are explanatory diagrams showing manufacturing steps in a second embodiment of the invention;

FIGS. 3A through 3E are explanatory diagrams showing manufacturing steps in a third embodiment of the invention; and

FIGS. 4A, 4B, 5A and 5B are graphical representations for a description of the contact characteristics of field effect transistors which are manufactured according to the invention.

Preferred embodiments of the invention will be described with reference to the accompanying drawings.

In a first embodiment of the invention, the technical concept of the invention is applied to a method of manufacturing n channel MOS FET's.

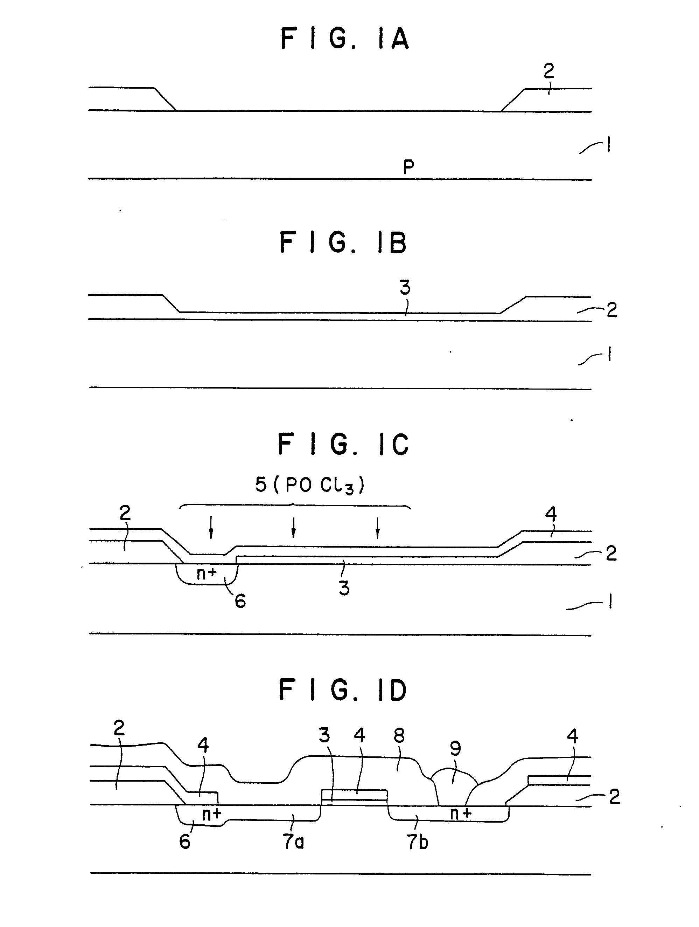

As shown in FIG. 1A, a p type silicon substrate 1 is thermally oxidized to form a silicon oxide film 2 about 800 nm (8000 Å) in thickness for patterning. Thereafter, oxidization is further carried out to form a gate oxide film 3 about 50 nm (500 Å) in thickness for patterning electrodes as shown in FIG. 1B.

Then, as shown in FIG. 1C, silicon Si and molybdenum Mo are deposited by evaporation to form an $MoSi_2$ film 4 having a thickness of about 300 nm (3000 Å). Under this condition, $POCl_3$ is diffused (as indicated by reference numeral 5) from the surface at 900°C for forty (40) minutes. As a result, the specific resistance of the $MoSi_2$ film 4 is decreased, while phosphorus P is doped, in a self-alignment manner, into only the region where the silicon substrate 1 is in contact with the film 4, thus forming a region 6 for ohmic contact.

After a patterning process, ion implantation of arsenic (As) is carried out with 40 KeV, to form a source region 7a and a drain region 7b as shown in FIG. 1D. Finally, an $SiO_2$ film 8 is formed as a passivation film by the CVD method. In addition, an aluminum film 9 is formed for mutual connection wiring and input and output wiring.

The silicon oxide film 2 is used for insulation. Therefore, other materials may be employed.

A second embodiment of the invention, in which the technical concept of the invention is applied to a polysilicon structure, will be described.

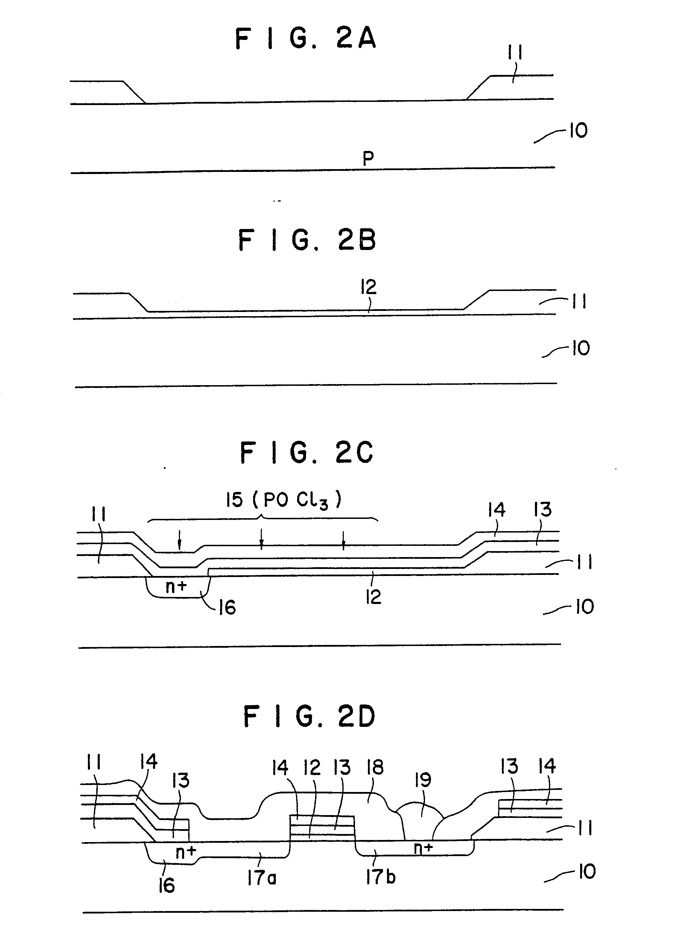

Similarly as in the first embodiment, a gate oxide film 12 and insulating film 11 are formed as shown in FIGS. 2A and 2B.

As shown in FIG. 2C, silicon (Si) is deposited by vacuum evaporation to form a polysilicon layer 13 about 200 nm (2000 Å) in thickness, and then silicon (Si) and molybdenum (Mo) are deposited by vacuum evaporation simultaneously to form a MoSi film 14 about 200 nm (2000 Å) in thickness. Under this condition, $POCl_3$ is diffused (indicated at 15) from the surface at 900°C for forty (40) minutes, as a result of which a region where the polysilicon layer 13 and the $MoSi_2$ film 14 are in contact with each other and a region 16 where the polysilicon layer 13 is in contact with the silicon substrate 10 become ohmic.

After a patterning process, ion implantation arsenic (As) is carried out with 40 KeV to form a source region 17a and a drain region 17b. Finally, an $SiO_2$ film 18 is formed as a passivation film by the CVD method. In addition, an aluminum film 19 is formed for mutual connection wiring and input and output wiring.

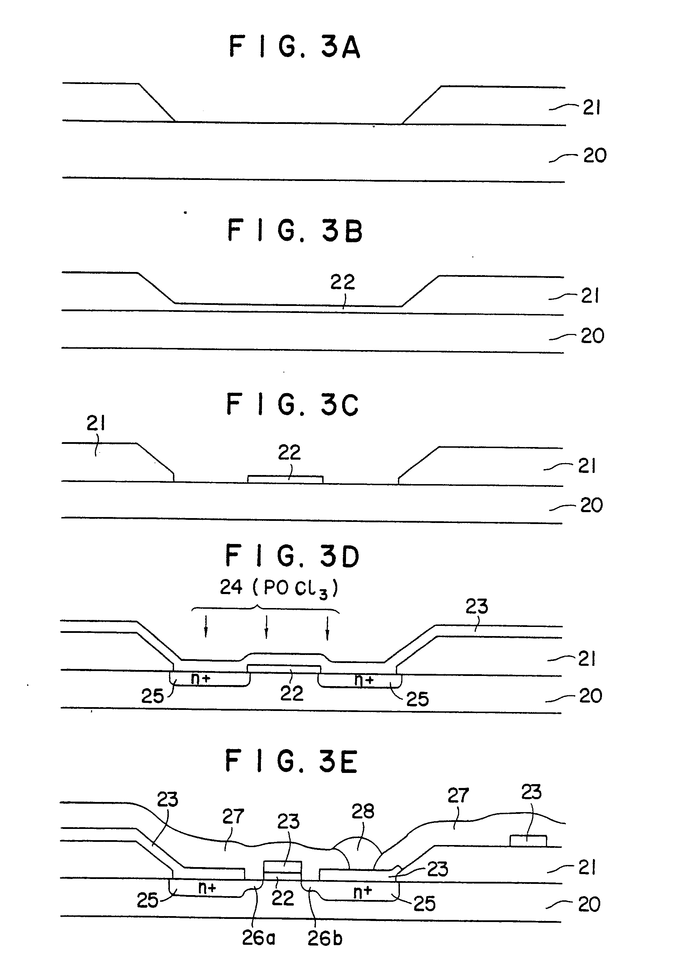

A third embodiment of the invention will be described with reference to FIGS. 3A through 3E. The embodiment is to reduce the source-drain resistance of a MOS transistor, thereby to improve its drive characteristic.

Similarly as in the first or second embodiment, a silicon oxide film 21 and a gate oxide film 22 are formed (FIGS. 3A and 3B).

Patterning is carried out as shown in FIG. 3C.

Thereafter, as shown in FIG. 3D, silicon (Si) and molybdenum (Mo) are deposited by vacuum evaporation simultaneously to form an $MoSi_2$ film 23 about 300 nm (3000 Å) in thickness. Under this condition, diffusion of $POCl_3$ is carried out at 900°C for forty minutes (as indicated at 24), as a result of which phosphorus (P) is doped, in a self-alignment manner, only into the region where the silicon substrate 20 is in contact with the film 23, thus forming ohmic contact regions 25.

After a patterning process, ion implantation of arsenic (As) is carried out with 40 KeV, to form a source region 26a and a drain region 26b.

Thereafter, as shown in FIG. 3E, an $SiO_2$ film 27 is formed as a passivation film by the CVD method, and an aluminum film 28 is formed for mutual connection wiring and input and output wiring.

According to the third embodiment the source-drain resistance can be reduced from 40 $\Omega/cm^2$ to 3 $\Omega/cm^2$ in the case of an n-channel FET.

In the above-described embodiments, the $MoSi_2$ film is employed as the gate material; however, the same effect can be obtained with silicides such as $WSi_2$ and $TiSi_2$ or metals such as Mo and W.

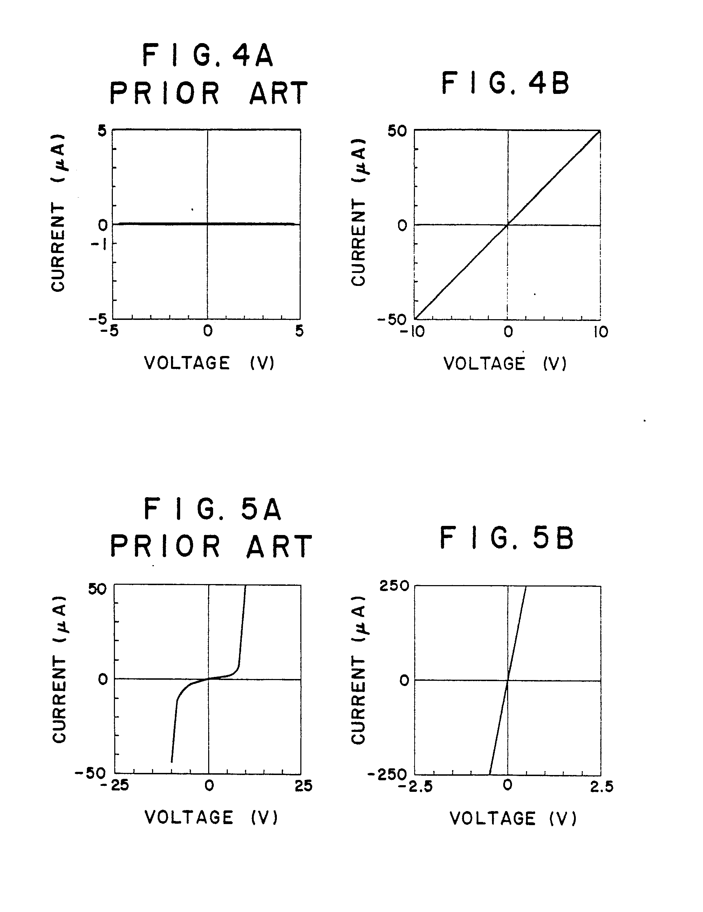

Heretofore, the contact characteristic of silicon and $MoSi_2$ film is insufficient as shown in FIG. 4A; however, it has been improved as shown in FIG. 4B according to the invention. Furthermore, according to the invention, the contact characteristic of polysilicon and $MoSi_2$ film as shown in FIG. 5A is improved into that as shown in FIG. 5B. The contact resistance is also improved to 4 to $6 \times 10^{-7}$ $\Omega/cm^{-2}$.

As is apparent from the above description, the films for wiring and electrodes are made of metal silicide, and therefore the specific resistance is small when compared with that of the films for wiring and electrodes which are made of polycrystal silicon. Accordingly, the FET manufactured according to the invention can be operated at high speed. Furthermore, according to the invention, impurities can be doped, in a self-alignment manner and with high density, in the portion of the silicon substrate where the ohmic contact region is formed, which makes it possible to manufacture high density LSI's. In addition, the phosphorus ions ($P^-$) included in the gate electrode 4 work as a getter in the insulating film 2, which provides stability and reliability for the gate electrode and improves the threshold value of the transistor.

**Claims**

1. A method of manufacturing an FET comprising:

forming a first insulating film (3, 12, 22) on the surface of a semiconductor substrate (1, 10, 20);

removing a portion of said first insulating film (3, 12, 22) from said substrate surface to form an exposed portion of said substrate;

forming a metal silicide film (4, 14, 23) on said first insulating film and on said exposed portion of the substrate, by simultaneously evaporating metal and silicon onto said exposed portion and insulating film; thereafter

introducing impurities into the surface of said substrate (1, 10, 20) from outside the metal silicide covered substrate through said metal silicide film so as to decrease the specific resistance of the metal silicide film and to form in said exposed portion of the substrate an ohmic contact region for the source and/or drain region of said FET; and

forming said source region (7a, 17a, 26a) and said drain region (7b, 17b, 26b) of said FET in said substrate.

2. A method according to claim 1, wherein said ohmic contact region is formed at a contacting area between said substrate and said metal silicide film.

3. A method according to claim 1, wherein silicon (13) is evaporated on said insulating film and on said exposed portion of said substrate so as to form a polysilicon layer before said metal silicide film (14) is formed, said ohmic contact region being formed at a contacting area of said substrate and said polysilicon layer.

4. A method according to any one of claims 1 to 3, wherein said metal silicide film is made up of a material selected from the group consisting of tungsten silicide ($WSi_2$), titanium silicide ($TiSi_2$), and platinum silicide (PtSi).

5. A method according to any one of the preceding claims in which a second insulating film (2, 11, 21) is formed on a first part of the surface of a semiconductor substrate, and as said first insulating film a gate oxide film (8, 12, 22) is formed on a second part of the surface of said semiconductor substrate; phosphorous is diffused into said substrate by exposing said first insulating film and said metal silicide film to $POCl_3$ and a portion of said metal silicide film and the underlying gate oxide film is removed to form an insulated gate (3, 4; 13, 14; 22, 23).

6. A method according to any one of the preceding claims in which said source and drain regions are formed by ion-implantation.

7. A method according to claim 6 when dependent on claim 5, wherein said source and drain regions are formed by ion-implantation of arsenic.

**Patentansprüche**

1. Verfahren zur Herstellung eines FET, das folgende Schritte umfasst:

Aufbringen einer ersten isolierenden Schicht (3, 12, 22) auf der Oberfläche eines Halbleitersubstrates (1, 10, 20);

Entfernen eines Teils der genannten ersten isolierenden Schicht (3, 12, 22) von der genannten Substratoberfläche zur Bildung eines freiligenden Teils des genannten Substrates;

Aufbringen einer Silicidschicht (4, 14, 23) auf die genannte erste isolierende Schicht und den genannten freiliegenden Teil des Substrates durch gleichzeitiges Aufdampfen von Metall und Silicium auf den genannten freiliegenden Teil und die isolierende Schicht;

danach Einführen von Verunreinigungen in die Oberfläche des genannten Substrates (1, 10, 20) von ausserhalb des mit Metallsilicid überzogenen Substrates durch die genannte Metallsilicidschicht, um den spezifischen Widerstand der Metallsilicidschicht zu verringern und einen Ohm-'schen Kontaktbereich für den Quellen- und/oder Senkenbereich des genannten FET in dem genannten freiliegenden Bereich des Substrates anzulegen;

Aufbau des genannten Quellenbereiches (7a, 17a, 26a) und des genannten Senkenbereiches (7b, 17b, 26b) des genannten FET in dem genannten Substrat.

2. Verfahren gemäss Anspruch 1, dadurch gekennzeichnet, dass der genannte Ohm'sche Kontaktbereich in einem Kontaktbereich zwischen dem genannten Substrat und der genannten Metallsilicidschicht aufgebaut wird.

3. Verfahren gemäss Anspruch 1, dadurch gekennzeichnet, dass Silicon (13) auf die genannte isolierende Schicht und den genannten freiliegenden Teil des genannten Substrates aufgedampft wird, um eine Auflage aus Polysilicon aufzubauen, bevor die genannte Metallsilicidschicht (14) gebildet wird, wobei der genannte Ohm'sche Kontaktbereich in einem Kontaktbereich zwischen dem genannten Substrat und der Auflage aus Polysilicium gebildet wird.

4. Verfahren gemäss einem der Ansprüche 1 bis 3, dadurch gekennzeichnet, dass die genannte Metallsilicidschicht aufgebaut wird aus einem Material, das gewählt wird aus der Gruppe Wolframsilicid ($WSi_2$), Titansilicid ($TiSi_2$) und Platinsilicid (PtSi).

5. Verfahren gemäss einem der Ansprüche 1 bis 4, dadurch gekennzeichnet, dass eine zweite isolierende Schicht (2, 11, 21) auf einem ersten Teil der Oberfläche des Halbleitersubstrates aufgetragen wird, dass als genannte erste isolierende Schicht eine Gateoxidschicht (8, 12, 22) auf einem zweiten Teil der Oberfläche des genannten Halbleitersubstrates aufgetragen wird, dass Phosphor in das genannte Substrat diffundiert wird, indem die genannte erste isolierende Schicht und die genannte Metallsilicidschicht $POCl_3$ ausgesetzt wird und dass ein Teil der genannten Metallsilicidschicht und die darunterliegende Gateoxidschicht entfernt werden, um ein isoliertes Gate (3, 4, 13, 14, 22, 23) aufzubauen.

6. Verfahren gemäss einem der Ansprüche 1 bis 5, dadurch gekennzeichnet, dass die genannten Quellen- und Senkenbereiche durch Ionenimplantation erzeugt werden.

7. Verfahren gemäss den Ansprüche 5 und 6, dadurch gekennzeichnet, dass die genannten Quellen- und Senkenbereiche durch Ionenimplantation von Arsen erzeugt werden.

**Revendications**

1. Procédé de fabrication d'un transistor FET, consistant à:

— former une première pellicule isolante (3, 12, 22) sur la surface d'un substrat semiconducteur (1, 10, 20);

— retirer une partie de ladite première pellicule isolante (3, 12, 22) de ladite surface du substrat de manière à former une partie à nu dudit substrat;

— former une pellicule d'un siliciure métallique (4, 14, 23) sur ladite première pellicule isolante et sur ladite partie à nu du substrat, grâce à l'exécution simultanée d'un dépôt par évaporation d'un métal et de silicium sur ladite partie à nu et sur ladite pellicule isolante; puis

— introduire des impuretés dans la surface dudit substrat (1, 10, 20) à partir de l'extérieur du substrat recouvert par le siliciure métallique, à travers ladite pellicule de silicium métallique, de manière à réduire la résistance spécifique de cette pellicule de siliciure métallique et former, dans ladite partie à nu du substrat, une région de contact ohmique pour la région de source et/ou de drain dudit transistor FET; et

— former ladite région de source (7a, 17a, 26a) et ladite région de drain (7b, 17b, 26b) dudit transistor FET dans ledit substrat.

2. Procédé selon la revendication 1, selon lequel ladite région de contact ohmique est formée dans une zone de contact entre ledit substrat et ladite pellicule de siliciure métallique.

3. Procédé selon la revendication 1, dans lequel on dépose par évaporation du silicium (13) sur ladite pellicule isolante et sur ladite partie à nu dudit substrat de manière à former une couche de polysilicium avant que ladite pellicule de silicium métallique (14) soit formée, ladite région de contact ohmique étant formée dans une zone de contact entre ledit substrat et ladite couche de polysilicium.

4. Procédé selon l'une quelconque des revendications 1 à 3, selon lequel ladite pellicule de siliciure métallique est constituée en un matériau sélectionné dans le groupe incluant le siliciure de tungstène ($WSi_2$), le siliciure de titane ($TiSi_2$) et le siliciure de platine (PtSi).

5. Procédé selon l'une quelconque des revendications précédentes, selon lequel on forme une seconde pellicule isolante (2, 11, 21) sur une première partie de la surface d'un substrat semiconducteur, et l'on forme, en tant que première pellicule isolante, une pellicule d'oxyde de grille (8, 12, 22) sur une seconde partie de la surface dudit substrat semiconducteur; on fait pénétrer par diffusion du phosphore dans ledit substrat en exposant ladite première pellicule isolante et ladite pellicule de siliciure métallique à du $PoCl_3$, et l'on élimine une partie de ladite pellicule de siliciure métallique et de la pellicule sous-jacente d'oxyde de grille de manière à former une grille isolée (3, 4; 13, 14; 22, 23).

6. Procédé selon l'une quelconque des revendications précédentes, selon lequel on forme lesdites régions de source et de drain par implantation ionique.

7. Procédé selon la revendication 6, considérée comme dépendante de la revendication 5, selon lequel on forme lesdites régions de source et de drain au moyen d'une implantation d'ions d'arsenic.

# F I G. IA

# F I G. IB

# F I G. IC

5 ( PO $Cl_3$ )

# F I G. ID

# F I G. 2A

# F I G. 2B

# F I G. 2C

15 ( PO Cl₃ )

# F I G. 2D

# F I G. 3A

# F I G. 3B

# F I G. 3C

# F I G. 3D

$24 \, (PO\,Cl_3)$

# F I G. 3E

# FIG. 4A
# PRIOR ART

# FIG. 4B

# FIG. 5A
# PRIOR ART

# FIG. 5B